# EUROPEAN PATENT APPLICATION

(11) **EP 4 563 983 A1**
(43) Date of publication of application: **04.06.2025**
(21) Application number: 23213562.4
(22) Date of filing: 30.11.2023
(51) Int. Cl.: G01N 21/956, G03F 7/20, G06T 7/00

(54) **PICTURE BASED IMAGING QUALITY ANALYSIS**

(71) Applicant: Esko-Graphics Imaging GmbH, 25524 Itzehoe (DE)
(72) Inventor: BÖTCHER, Joris, CH-8105 Regensdorf (CH); PFAU, Markus, CH-8105 Regensdorf (CH); SIEVERS, Wolfgang, CH-8105 Regensdorf (CH)
(74) Representative: Jonas, Hans-Hermann

(57) **Abstract**

Method and system for performing quality analysis of an imaged printing plate precursor mask layer includes a detector and computer memory media programmed with machine-readable instructions. The mask layer has a plurality of openings created by a first imager corresponding to information including micro-screen information. The printing plate precursor includes a photopolymer to be cured by exposure to actinic radiation. The detector acquires a digital image of at least a sample portion of the openings formed in the mask layer corresponding to the micro-screen information for inspection. The first set of machine-readable instructions causes a processor to generate, based on the digital image, a first data array comprising a plurality of inspection parameters. The second set of machine-readable instructions causes a process to compare the plurality of inspection parameters from the first data array and a plurality of reference parameters from a second data array.

## Description

### BACKGROUND OF THE INVENTION

Transferring images to flexographic printing plates typically comprises placing a flexographic printing plate on a standard digital imager, such as a Cyrel^{®} Digital Imager (CDI^{™}), manufactured by Esko Graphic-Imaging GmbH of Itzehoe, Germany. State of the art flexographic printing plates typically have a Laser Ablatable Mask system (LAMs) layer disposed on top of the printing (front) surface of the plate.

In a typical first process step, the LAMs layer is partially removed by an infrared laser beam in the imager in a pattern corresponding to the image to the transferred. In a typical second process step, the photopolymer is selectively cured by UV light that penetrates the portions of the plate where the LAMs layer was removed. This second process step is usually done in a second device outside the imager. In a third process step, the non-cured portions of the photopolymer plate are selectively removed by a thermal or solvent process.

In the typical first process step, corresponding portions of the mask from the polymer plate corresponding to all solid printed regions of the image are completely removed by means of a laser beam modulated by an acousto-optical deflector. Later, after the discovery that micro-structures in solid regions provide better ink transfer, the use of "Pixel Boost" technology (e.g. boosting the laser power when ablating the portion of the mask corresponding to selected pixels relative to others, based on predetermined criteria) has become a standard technique employed by Esko in CDI imagers over the last decade. The boosting is accomplished by increasing the R.F signal to the acousto-optical deflector accordingly. Pixel boosting allows creation of micro screens in the mask of a digital photopolymer printing plate (e.g. DuPont^{®} Cyrel^{®} DPR) by ablating only individual single pixels. These single pixels are arranged in patterns that form surface structures in regions of the plate intended to transfer ink to the print substrate. The capability of ink transfer of such surface structures is optimized by choosing an optimum size for the individual mask openings. The size of the mask openings can be altered by adjusting the energy of the laser pulse that creates the mask opening. Additional information regarding exemplary such techniques can be found in U.S. Patent No. 11,142,013 ("the '013 Patent"), titled "Method for smoother tonal response in flexographic printing," incorporated herein by reference.

When imaging a laser-ablateable mask in a CDI imager, the mask openings are cut by a multitude of beams simultaneously. This multitude of beams can be operated in two different modes: standard imaging mode or pulsed mode. In standard imaging mode, the laser power for each individual beam is selected in a way that the size of the mask opening just slightly overlaps with the mask openings cut by neighboring beams. The beams are switched "on" continuously in solid rendition areas, according to the image information of the image to be printed, such that the opening in a mask for a solid rendition area extends across the entire solid rendition area. As used here, the term "solid rendition area" refers to an area of an image to which a halftone screen has not been applied, which image areas may also include "linework" - e.g. solid lines within a graphic image). This mode is used for standard imaging, and creates solid rendition screened areas, including linework, having no surface structures (e.g. while highlight areas may comprise a plurality of discrete and separated halftone dots formed on the plate, the surface of each solid rendition area is not textured). The laser power for each beam in this mode is nominally considered to be at 100% power. In pulsed mode, the beams are turned on for short periods. Not all beams are turned on at the same time. Instead, the beams are turned on in certain sequences, forming patterns of mask openings that build surface structures that are suitable for improved ink transfer. An exemplary method for forming such surface structures is disclosed in U.S. Patent No. 11,142,013 B2 ("the '013 Patent"), titled "METHOD FOR SMOOTHER TONAL RESPONSE IN FLEXOGRAPHIC PRINTING," which is incorporated herein by reference.

Exemplary state-of-the-art micro screen patterns are disclosed, for example, in PCT Application No. PCT/EP2021/083548, titled "SYSTEM AND METHOD FOR MITIGATING TRAILING EDGE VOIDS IN FLEXO PRINTING," the content of which is incorporated herein by reference. The different sizes of mask openings result in different structures on the completely processed polymer plate. These structures can be varied from individually separate standing micro screen dots to dots all touching another, leaving only small holes in between. Controlling the surface structures in the completely processed plate allows adjusting the surface properties of the plate for optimum print properties.

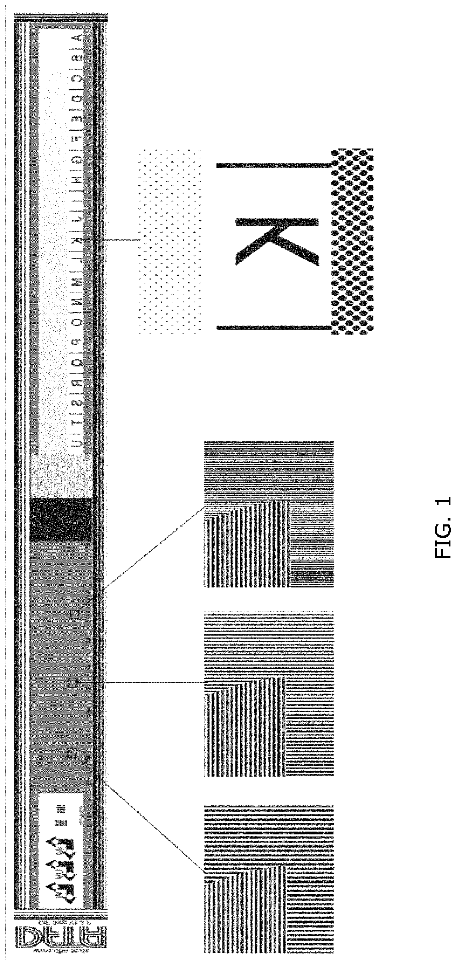

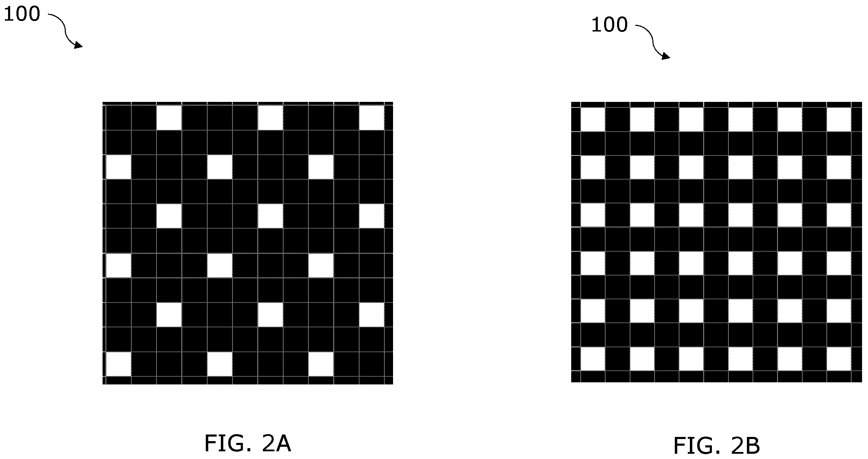

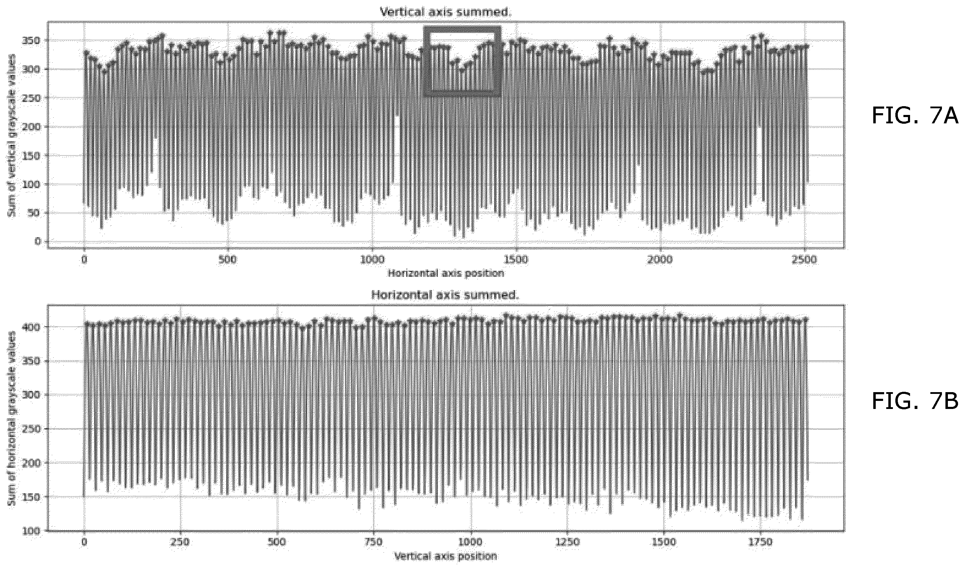

One of the challenges of using digital photopolymer printing plates concerns impartially or objectively assessing the imaging quality of CDI imaging on the LAMs layer. Criteria for assessing the imaging quality (e.g. the correct focus position of the imaging optics) are commonly assessed by human operators or technicians either by looking at the LAMs layer through a microscope or by measuring mask openings of test patterns which were imaged onto the LAMs layer at different focus positions by means of densitometers. When CDI imagers developed from single imaging beam to multibeam imagers that use 64 or more beams, additional criteria became relevant. For example, balancing between individual beams may be conventionally addressed by special test patterns such as the DFTA Test pattern, as developed by DFTA Flexodruck Fachverband e.V., depicted in FIG. 1. While DFTA Test pattern was designed for imagers having between 2 to 8 beams and image file resolutions between 2000 and 2540 DPI, when more imaging beams were later used, and the image file resolution went up to 4000 DPI or higher, more sophisticated patterns were developed and used. Non-limiting examples of such patterns are depicted in FIGS. 2A and 2B. Such patterns can also be applied as surface structures to improve ink transfer, as described, for example, in the aforementioned '013 Patent as well as in U.S. Patent No. 11,388,311 B2 ("the '311 Patent"), titled "SYSTEM AND METHOD FOR OBTAINING A UNIFORM INK LAYER," the contents of which is also incorporated herein by reference. Non-limiting examples of a selection of criteria for assessing the imaging quality include: power balancing of the imaging beams, distance between imaging beams, beam rake tilt, and circumferential position jitter of imaging beams. Other non-limiting examples of a selection of criteria for assessing the imaging quality, if single pixel microscreen patterns (e.g. MCWSI pattern, depicted in FIG. 7A of the '311 Patent) are imaged, include: correct circular shape of the mask openings, homogeneity of the mask openings, horizontal or vertical deviation of mask openings from the expected position, and undesired patterning in microscreens.

As mentioned above, state-of-the-art selection of criteria for assessing imaging quality of CDI imaging on the LAMs layer are assessed by humans, either by assessing pictures taken from the imaged LAMs layer or by directly looking at the LAMs layer through a magnifier or a microscope with illumination from the plates top- or backside. For example, the pictures of the imaged LAMs layer can be taken for example by the Flex³Pro^{™} flexo plate analyser, from Peret GmbH.

However, human sight is limited in terms of recognizing deviations from a homogeneous pattern, thereby not maximizing possible assessment of such deviations (and magnitude thereof). Thus, relying on human sight makes it difficult to use objective criteria when adjusting imaging systems or fixing problems related to imaging quality, because changes are applied to the imaging system depends on the individual perception and capabilities of the technician or human operator.

Thus, there is a need for an improved systems and methods of impartially assessing imaging quality using microscreen patterns.

### BRIEF DESCRIPTION OF DRAWINGS

FIG. 1 depicts an exemplary test pattern in accordance with prior art;
FIGS. 2A-2B depict exemplary test patterns in accordance with aspects of the invention;
FIG. 3 depicts an exemplary microscreen pattern on a LAMs for use in accordance with aspects of the invention;
FIG. 4 depicts exemplary data array generated based on the pattern of FIG. 3 in accordance with aspects of the invention;
FIG. 5 depicts an exemplary display of an image quality assessment in accordance with aspects of the invention;
FIG. 6A depicts another digital image in accordance with aspects of the invention;
FIG. 6B depicts an exemplary ideal reconstruction of the digital image of FIG. 6A, in accordance with aspects of the invention;
FIG. 7A depicts a graph showing average light transmission of each vertical image slice oriented parallel to mask openings in accordance with aspects of the invention;
FIG. 7B depicts a graph showing average light transmission of each horizontal image slice parallel to mask non-openings in accordance with aspects of the invention;
FIG. 7C depicts a graph showing average light transmission of each image slice parallel to mask non-openings in accordance with aspects of the invention;
FIG. 8 depicts an exemplary system for performing an image quality analysis of a printing plate in accordance with aspects of the invention;
FIG. 9 depicts an exemplary method for performing an image quality analysis of a printing plate in accordance with aspects of the invention;
FIG. 10A is a schematic drawing depicting an exemplary image acquisition system in accordance with aspects of to the invention;
FIG. 10B is a schematic drawing depicting an exemplary image acquisition system integrated with linear exposure sources in a flatbed system;
FIG. 10C is a schematic drawing depicting an exemplary image acquisition system integrated with a drum-based exposure system;
FIG. 10D is a schematic drawing depicting another exemplary image acquisition system integrated with a drum-based exposure system;
FIG. 11 depicts an exemplary arrangement of light transmission via mask openings when illuminated from a front or printing side of the printing plate in accordance with aspects of the invention;
FIG. 12 depicts another exemplary arrangement of light transmission via mask openings when illuminated from a front or printing side of the printing plate in accordance with aspects of the invention;
FIG. 13 depicts yet another an exemplary arrangement of light transmission via mask openings when illuminated from a front or printing side of the printing plate in accordance with aspects of the invention; and
FIG. 14 is a schematic drawing depicting an exemplary system facilitating illumination from a front or printing side of the printing plate in accordance with aspects of the invention.
FIGS. 15A-15D are prophetic graphs illustrating exemplary measured relative beam intensity (in percentage) when each of beams 1, 3, 7 and 9, respectively, in an array of 9 beams is turned on alone.
FIG. 16A is a prophetic graph illustrating exemplary measured relative beam intensity (in percentage) when all of beams 1-9 in an array of 9 beams are turned on in an unbalanced state.
FIG. 16B is a prophetic graph illustrating exemplary measured relative beam intensity (in percentage) when all of beams 1-9 in the array of 9 beams are turned on in a balanced state when balanced according to prior art.
FIG. 16C is a prophetic graph illustrating exemplary measured relative beam intensity (in percentage) when each of beams 1, 5, and 9 in an array of 9 beams are turned on simultaneously in a balanced state when balanced according to prior art.
FIG. 17A is a prophetic graph illustrating exemplary measured relative beam intensity (in percentage) when all of beams 1 - 9 in an array of 9 beams are turned on simultaneously in a balanced state according to the invention.
FIG. 17B is a prophetic graph illustrating exemplary measured relative beam intensity (in percentage) when each of beams 1, 5, and 9 in an array of 9 beams are turned on simultaneously in a balanced state according to the invention.
Fig. 18 is an exemplary graph showing a test pattern for analyzing individual beams by their mask opening.

### SUMMARY OF THE INVENTION

One aspect of the invention comprises a system for performing quality analysis of an imaged printing plate precursor mask layer having a plurality of openings created by a first imager corresponding to information in an image file. The information in the image file includes micro-screen information comprising a pattern of "on" and "off" single pixels or clusters thereof. The printing plate precursor comprises a photopolymer configured to be cured by exposure to actinic radiation through openings in a mask layer. The system has a detector configured for acquiring a digital image of at least a sample portion of the plurality of openings formed in the mask layer corresponding to the micro-screen information for inspection The system also includes computer memory media programmed with a first set of machine-readable instructions for causing a processor to analyze the digital image and generate, based on the digital image, a first data array comprising a plurality of inspection parameters related to each of the plurality of openings in the mask layer. The system has a computer memory media programmed with a second set of machine-readable instructions for comparing the plurality of inspection parameters from the first data array and a plurality of reference parameters from a second data array.

Another aspect of the invention comprises a method for performing quality analysis of an imaged printing plate precursor mask layer having a plurality of openings created by a first imager corresponding to information in an image file. The information in the image file includes micro-screen information comprising a pattern of "on" and "off" single pixels or clusters thereof. The printing plate precursor has a photopolymer configured to be cured by exposure to actinic radiation through openings in a mask layer. The method comprises the steps of imaging the mask layer of the printing plate according to the information in the image file by causing the controller connected to the imager to transform image information in the image file to commands for causing the imager to create the openings in the mask layer; generating a digital image of at least a sample portion of the plurality of openings formed in the mask layer corresponding to the micro-screen information for inspection; generating a first data array comprising a plurality of inspection parameters related to each of the plurality of openings in the mask layer; and comparing the plurality of inspection parameters from the first data array and a plurality of reference parameters from a second data array.

Yet another aspect of the invention comprises a non-transitory computer memory media programmed with machine-readable instructions for causing a processor to perform quality analysis of a printing plate mask layer created by an imager based upon information in an image file including micro-screen information comprising a pattern of "on" and "off" single pixels or clusters thereof. The instructions include a first set of instructions for retrieving a digital image of at least a sample portion of the openings formed in the mask layer corresponding to the micro-screen information for inspection. The instructions also have a second set of machine-readable instructions for analyzing the digital image and generating, based on the digital image, a first data array comprising a plurality of inspection parameters related to the individual openings in the mask layer. The instructions further include a third set of machine-readable instructions for comparing the plurality of inspection parameters from the first data array and a plurality of reference parameters from a second data array. The instructions include a fourth set of machine readable instructions comprising at least one of: (i) instructions for comparing the one or more deviations detected using a first instance of the first data array generated at a first time to the one or more deviations detected using a second instance of the first data array generated at a second time, and providing an alert if the comparison indicates a change over time greater than a predetermined threshold, and (ii) instructions for retrieving a third data array comprising at least the calculated average values of the plurality of inspection parameters (e.g. for one or more imagers other than the first imager, or based upon an ideal reconstructions of the data in the first data array), comparing the first data array or the second data array to the third data array, and detecting one or more deviations between the plurality of inspection parameters from the first data array or the second data array and the plurality of reference parameters from the third data array. The instructions also include a fifth set of machine-readable instructions comprising at least one of: (i) instructions for recommending or automatically initiating a change in at least one setting of the imager based upon the detected one or more deviations; and (ii) instructions for causing the processor to render, and an output device attached to the processor to output, an image visualizing the comparison of and deviations between the plurality of inspection parameters from at least two of the first instance of the first data array, the second instance of the second data array, the second data array, and the third data array. In embodiments, the changes in the at least one setting of the imager take the form of a reconfigured beam balancing instruction table, generated by applying correction factors to a prior beam balancing instruction table, wherein the correction factors are based upon the deviations between the first data array and ideal reconstructions based upon the first data array.

Thus, yet another aspect of the invention relates to a method for imaging beam balancing of an imager, the imager configured to emit a plurality of imaging beams for ablating a plurality of openings in a mask layer of a printing plate precursor in accordance with information in an image file, the imager comprising a controller configured to translate the information in the image file into an amount of energy selectively applied by the plurality of imaging beams to selected locations on the mask layer. The imager has initial beam balancing information stored in computer memory and used by the controller for defining a power intensity output supplied to each imaging beam. The method comprises imaging the mask layer of the printing plate with the imager according to the information in the image file using the initial beam balancing information, generating a digital inspection image of at least a sample portion of the plurality of openings formed in the mask layer imaged using the initial beam balancing information, generating a first data array comprising a plurality of inspection parameters related to each of the plurality of openings in the mask layer of the digital inspection image; generating a reference data array comprising a reconstruction of the first data array with idealized reference parameters for each of the plurality of openings in the mask layer generated from data in the first data array, and detecting and calculating one or more deviations between corresponding reference parameters and inspection parameters. A set of one or more correction factors for modifying the power intensity output of the one or more imaging beams is developed based upon the detected and calculated one or more deviations, and the one or more correction factors are applied to the existing beam balancing information to form corrected beam balancing information.

### DETAILED DESCRIPTION OF THE INVENTION

One aspect of the invention addresses the problem of image quality assessments of an imager for digital plates by analyzing microscreen patterns corresponding to different settings for "on" and "off" pixels in various regions of the printed image. Aspects of the invention also relate to specific methods for performing image quality assessments.

As mentioned above, selection of criteria for assessing imaging quality of CDI imaging on the LAMs layer are typically assessed by humans, and aspects of the invention thus introduce a new approach to improve this assessment by analyzing microscreen patterns comprising mask openings formed by switching "on" single pixels or clusters of multiple pixels to determine one or more deviations relative to a reference appearance of the microscreen pattern. Exemplary microscreen patterns are illustrated in FIGS. 2A (referred to by the Applicant as an MCWSI pattern) and 2B ( referred to by the Applicant as a DDWSI pattern), but one skilled in the art would understand from the description herein that other test or microscreen patterns are applicable, including any pattern comprising mask openings created by switching "on" single pixels or clusters of multiple pixels. Still further, the exemplary systems and methods herein may be used to perform an image quality assessment of or based on Moire patterns.

As described further herein, the exemplary systems and methods described herein collect and analyze a plurality of data points related to the micro screen imaging parameters in an image of a flexographic printing plate when imaging the LAMs layer of the plate. In doing so, analysis of the microscreen test patterns improves the printing properties of the printing plate, such as the ink transfer property of the printing plate. In an exemplary embodiment, this improvement in printing properties of the printing plate is achieved by measuring the existing beam balancing on an imager 810 (CDI imager), comparing these measured values to predetermined or ideal readings of an idealized identical pattern, calculating correction values for all beams, and applying these correction values for imaging. Application of correction values can be established by replacing an existing balancing information stored by a controller (e.g. the control computer of the CDI), such that intensity values of all beams (e.g. in a beam balancing instruction table) are replaced or modified by corrected balancing information. In addition, the exemplary systems and methods are discussed herein in the context of assessing the imaging properties of an imager for digital photopolymer printing plates, but the exemplary systems and methods described herein can also be applied for Offset or Inkjet imagers or other imaging systems within the field of graphic arts. Likewise, although discussed herein with respect to a plate with a LAMs layer, the invention of analyzing a digital image of microscreen patterns to assess imaging quality as discussed herein is not limited only to LAMs layer mask technology, but can instead be applied broadly to other types of masking layers used during a curing step of a photopolymer plate (e.g. silver halide or thermal film-based masks), without limitation. Finally, as used herein, the term "printing plate" is intended to include, and may refer to, a printing plate precursor not yet completely finished or a finished plate ready to receive ink, the specifics of which will be clear from the context of the discussion herein. When necessary, the terms "finished printing plate" refers to a plate that is fully developed and ready to receive ink, and "plate precursor" refers to a plate at any stage of development prior to being a finished plate ready to receive ink.

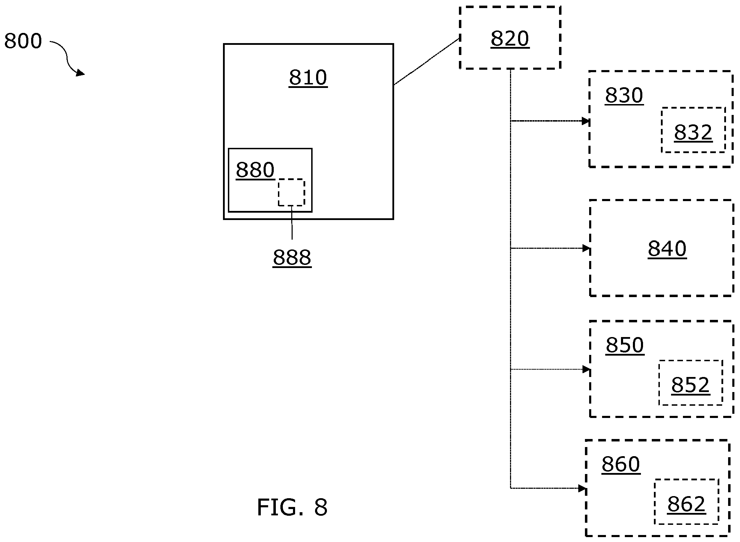

An exemplary system 800 for performing an image quality analysis of a printing plate having a printing surface corresponding to an information in an image file is shown in FIG. 8. As is well known in the art, a printing plate comprises a photosensitive polymer on which is disposed a mask that defines portions of the plate that are masked from radiation exposure relative to portions of the plate that are desired to receive such exposure (i.e. for curing). In a typical embodiment, the polymer, including in the mask area, is permeable to oxygen. Further, the information in the image file includes micro-screen information comprising a pattern of "on" and "off" single pixels or clusters thereof (as shown in FIGS. 2A-2B, for example).

An exemplary system 800 for carrying out embodiments of the invention described herein, as depicted in FIG. 8, comprises an imager 810 (such as the Esko^{®} CDI imager), a controller 820 for the imager 810, and computer memory media 830 programmed with a first set of machine-readable instructions 832, a detector 880, a computer memory media 850 programmed with a second set of machine-readable instructions 852, and computer memory media 860 programmed with a third set of machine-readable instructions 862. In an exemplary embodiment, the plurality of reference parameters and plurality of inspection parameters may comprise but is not limited to a size, a shape, a position, an orientation, and a homogeneity of the openings formed in the mask layer. Optionally, computer memory media 840 is configured to store measurements and other data collected during a cycle of image quality assessment (e.g. performed in accordance with method 900 discussed below) of one or more printing plates.

In an exemplary embodiment, the first set of machine-readable instructions 832 is configured to cause the controller 820 connected to the imager 810 to transform image information in the image file to commands for causing the imager 810 to create the openings in the mask layer. In an exemplary embodiment, at least 5000 mask openings should be formed in the mask layer. As is known in the art, creation of micro screens in the mask of a digital photopolymer printing plate (e.g. DuPont^{®} Cyrel^{®} DPR) is performed by ablating individual single pixels that are arranged in patterns forming surface structures in regions of the plate intended to transfer ink to the print substrate. Printing plate properties, such as capability of ink transfer of such surface structures, can be optimized based on a characteristic of the individual mask openings formed, e.g. an optimum size for the individual mask openings. The different sizes of mask openings result in different structures on the completely processed polymer plate. In one example, structures can be varied from individually separate standing micro screen dots to dots all touching another, leaving only small holes in between. Controlling the surface structures in the completely processed plate allows adjusting the surface properties of the plate for optimum print properties.

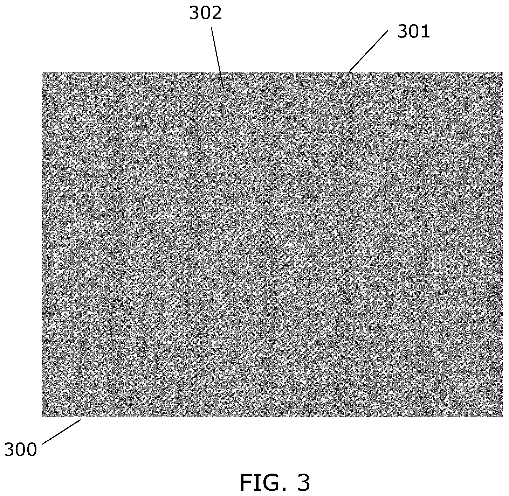

To facilitate an assessment of the imaging properties of imager 810 for digital photopolymer printing plates via digital image analysis, system 800 includes the detector 880. In one non-limiting example, the detector 880 is integrated with the imager 810. Alternatively, the detector 880 is external and separate from the imager 810, such as in an embodiment in which the detector is a stand-alone device located at a light table where the imaged plates are inspected. The detector 880 is configured for generating a digital image of a sample portion of at least the openings formed in the mask layer corresponding to the micro-screen information for inspection. In an exemplary embodiment, the detector 880 comprises a camera 888 (FIG. 8) and optionally, one or more optical elements to generate a magnified digital image of the sample portion. The detector 880 should preferably provide minimal optical distortion, and if distortions do exist, corrective actions may be performed, including taking pictures of a reference grid that is known to be linear and compensating for the distortions visible in the digital image. In one example, the camera 888 comprises a plurality of pixels that is at least 500 times more than a number of the imaged openings in the sample portion for inspection. In still another example, the camera 888 includes a resolution of 5 megapixels or higher. Exemplary cameras 888 include a Bresser^{®} model DST-1028 camera having 5.1 megapixels, a Basler^{®} acA4024-29um USB 3.0 camera with the Sony^{®} IMX 226 CMOS sensor. When the detector 880 includes an optical element for magnification, a magnification setting may be set to 200, which permits imaging of approximately 5000 spots of an exemplary microscreen pattern 300, such as one of the patterns depicted in FIGS. 2A-2B and 3 (the latter of which is referred to by the Applicant as a MCDWS pattern).

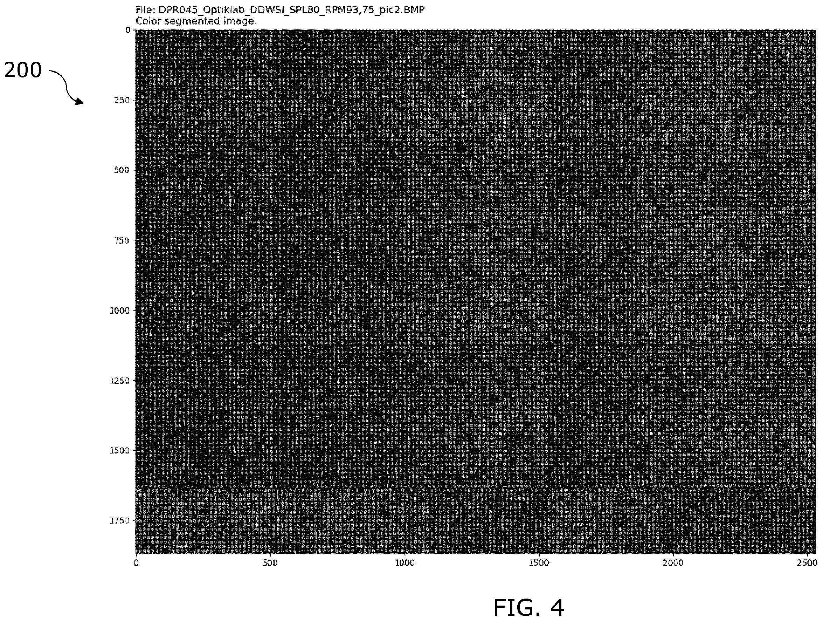

In an exemplary embodiment, the second set of machine-readable instructions 852 comprise instructions for causing the detector 880 to generate the digital image, non-limiting examples of which are illustrated in FIGS. 2A and 3 showing an exemplary MCWSI screen 300. Based on this digital image, a first data array 200 related to the digital image of the microscreen 300 is generated, the first data array 200 being illustrated as a matrix of data points in FIG. 4. One skilled in the art would understand that the data points related to the characteristics of the individual openings of the mask layer may be illustrated, organized, displayed, and/or stored in other means, such as a row of data storage cells instead of a matrix. The first data array 200 includes a plurality of inspection parameters related to the individual openings created in the mask layer. In one example, the second set of machine-readable instructions 852 comprise instructions for calculating an average value for each respective one of the plurality of inspection parameters. In this way, the second set of machine-readable instructions 852 also includes instructions for generating a second data array comprising optimal parameters by assessing the plurality of inspection parameters and the calculated average values thereof.

Additionally, or optionally, the third set of machine-readable instructions 862 comprise instructions for comparing the plurality of inspection parameters from the first data array and a plurality of reference parameters from the second data array. In an exemplary embodiment, the third set of machine-readable instructions 862 comprise instructions for calculating one or more deviations, if any, between the plurality of inspection parameters from the first data array and the plurality of reference parameters from the second data array. Thus, in operation, the third set of machine-readable instructions 862 comprise instructions for detecting one or more deviations between a data point from the first data array and a corresponding data point from the second data array. In an exemplary embodiment, analysis or comparison of the data points are performed using an image analysis algorithm embodied in software programmed in Python). Other image analysis software, operating systems, or programming systems equipped with capabilities for analyzing a digital image or photo of a micro screen pattern (e.g. MCWSI) are also applicable for performing the exemplary systems and methods described herein. In this way, imaging imperfections or deviations from a predetermined reference or setting of an imaging quality of the printing plate can be identified by the systems and methods described herein.

Corrective steps or actions following identification of the problem are thus made possible. For example, the disclosed systems and methods herein can be used for quality check purposes, such as during manufacturing or servicing of CDI imaging systems. In one non-limiting example, balancing between individual beams of multibeam imagers is achieved by performing the exemplary imaging quality assessments disclosed herein. Conventional imagers usually have a set of instructions for the beams that are used for imaging, but these instructions are typically limited to parameters or settings related to absolute output power in physical dimensions e.g. Watts.

The CDI imaging system comprises an acousto-optical deflector that transfers RF signals into optical beams split from a laser, with each beam having a direction dependent upon the frequency and intensities of the RF signal amplitude, such as is described in more detail in U.S. Pat. No. 5,654,125, titled LASER APPARATUS AND PROCESS OF USE, incorporated herein by reference. Although the invention as described herein is applicable to any type of imager, the exemplary embodiment as described herein relates to such an acousto-optical embodiment.

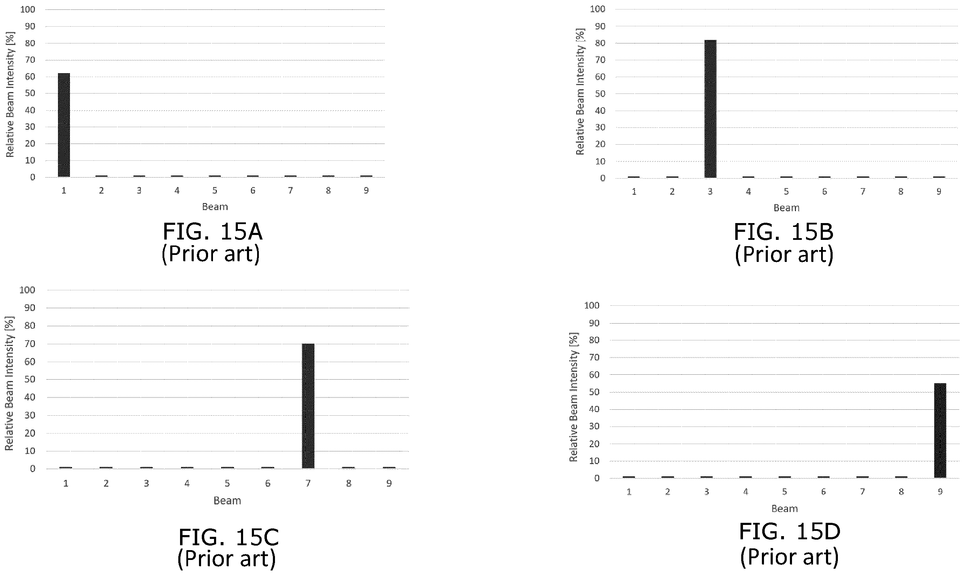

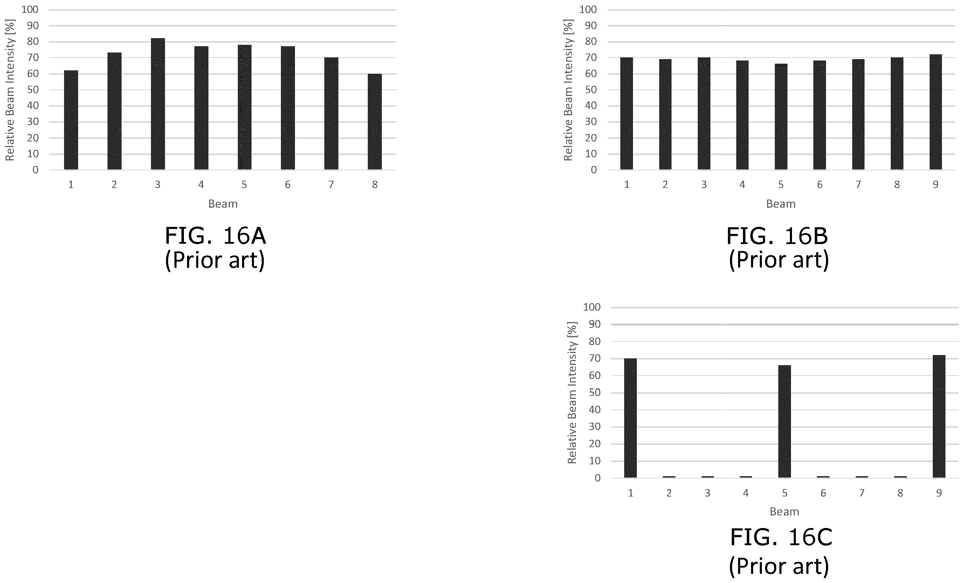

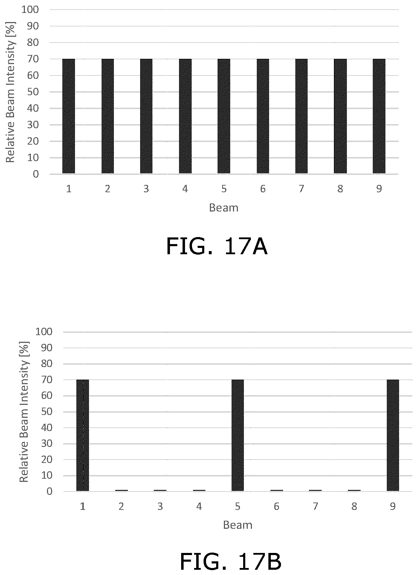

Most prior art imagers create balancing information based on summarized measurements of the active beams. In a first step, the light intensity for each physical beam is switched on at a constant drive signal and is measured individually by a photodiode. That is, only one beam at a time is switched on during the measuring period. For example, the balancing information for each individual beam is measured in a first step by switching on each single beam individually at a constant drive power, as depicted in FIGS. 15A-15D, which show a relative beam percent intensity for beams 1, 3, 7, and 9 of a 9 beam system, which schematically depicts the relation between individual beams (and their position in the frequency range) and their light intensity measured somewhere between the modulator and the imaging drum of the imager. Those of skill in the art will understand that each of the remaining beams in the array (2, 3-6, and 8) have similar measurement steps and corresponding graphs. Depending on the properties of the optical system, each of these beams may produce a slightly different optical power despite use of the same RF drive power. For example, beam 1 in FIG. 15A registers at slightly above 60%, whereas beam 3 in FIG. 15B registers at slightly above 80%, beam 7 in FIG. 15C registers at about 70%, and beam 9 in FIG. 15D registers at about 55%. Typically, the outer beams have less intensity than the center beams in an unbalanced state, as depicted in FIG. 16A. FIG. 16B depicts "ideal" balancing according to the prior art methods. Beam patterns other than "all beams on" (e.g. the pattern of beams 1, 5, and 9 on, as depicted in FIG. 16C) typically have some intensity mismatch after the prior art balancing step involving measurement of only one beam at a time, but this mismatch can be reduced, such as shown in the more ideally balanced depiction in FIG. 17A, when using the balancing method as described herein.

As illustrated, in the prior art balancing method, optical power is measured for every beam (e.g. as illustrated in FIGS. 15A-15D) and the information as measured is used for creating a balancing instruction table, which includes parameters to be applied to each beam to create a more balanced output. In a second measurement step all beams for a certain beam combination are switched on and measured together, without knowing the individual contribution of each beam. During this measurement, the balancing information derived from the first step is applied. The total drive power is then modified using the balancing relationships until the total power complies with the target power. This results in a more balanced arrangement, such as is depicted in FIG. 16B.

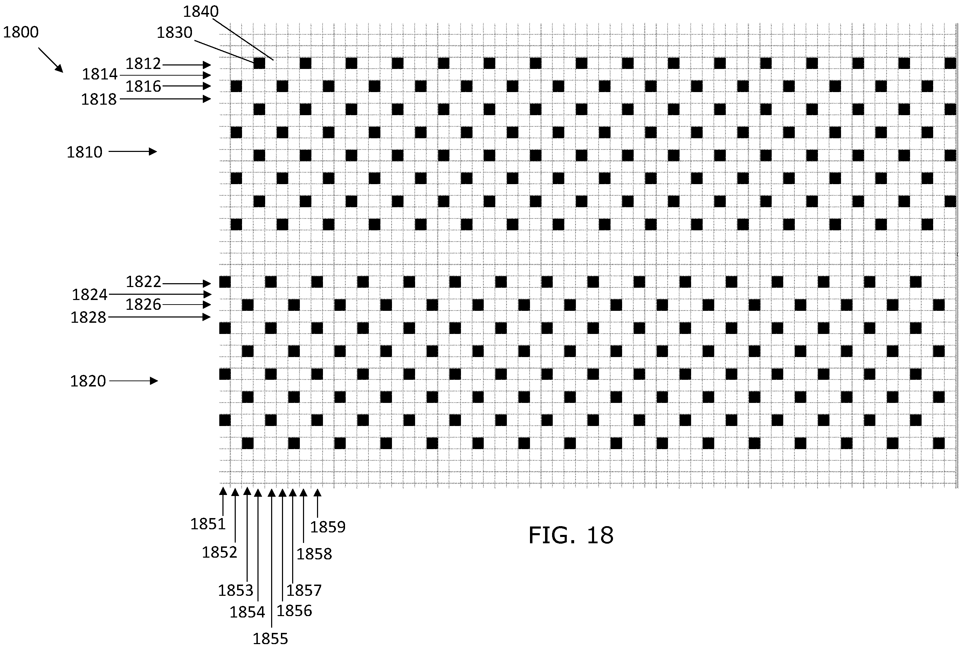

The systems and methods as described herein facilitate a different approach, wherein the intensity of each active beam may be assessed in a single step by switching on all beams of the certain beam combination to be examined, capturing a digital image of the resulting mask openings, analyzing the mask openings created by the different beams, and adjusting the balancing settings accordingly. This process is facilitated by use of a special imaging pattern comprising complimentary groups of shifted rows and columns of pixels, for example, as shown in FIG. 18 and discussed in more detail below, such that all beams are visible in the pattern. This is an iterative process that commences with analysing the results of an existing set of beam balancing information, meaning that either a conventional two-step balancing method as described above is executed first, or a default balancing is applied for the imaging step that is afterwards analyzed by the methods as described herein.

Thus, in an exemplary embodiment, the systems and methods disclosed herein provide a plurality of balancing instructions comprising correction factors that are calculated from a comparison or assessment of one or more deviations detected between the plurality of inspection parameters, such as from the first data array or the second data array, and the plurality of reference parameters, such as from the third data array.

Accordingly, a method for imaging beam balancing of an imager may include imaging the mask layer of the printing plate with the imager according to the information in the image file using the initial beam balancing information, such as provided by creating balancing information based upon a single beam at a time measurement as illustrated in FIGS. 15-A-D, and then generating a digital inspection image of at least a sample portion of the plurality of openings formed by a suitable test pattern in the mask layer imaged using the initial beam balancing information.

FIG. 18 illustrates an exemplary test pattern 1800. The pattern comprises a first grouping 1810 of "on" pixels 1830 arranged in rows and columns with "off" pixels 1840 separating the "on" pixels, and a second grouping 1820 of on pixels and off pixels, in which the "on" pixels are shifted relative to those in the first group. Specifically, group 1810 comprises a first row 1812 comprising an "on" pixel 1830 in every fourth column, with "off" pixels 1840 forming a gap between the "on" pixels (i.e. columns 1851, 1852, 1853, 1855, 1856, and 1857, have off pixels and columns 1854 and 1858 have an on pixel in row 1812), a second row 1814 with only "off" pixels, and a third row 1816 with a "on" pixel every fourth column, but with the "on" columns in row 1816 centered between the "on" columns of row 1812 (i.e. columns 1851, 1853, 1854, 1855, 1857, 1858, and 1859 have off pixels and columns 1852 and 1856 have an on pixel in row 1816). A fourth row 1818 contains only "off" pixels. This four-row pattern repeats four times. Group 1820 comprises a first row 1822 comprising an "on" pixel in every fourth column, with "off" pixels forming a gap between the "on" pixels, but with the on pixels located in a column not having an on pixel in group 1810 (i.e. columns 1852, 1853, 1854, 1856, 1857, and 1858 have off pixels and columns 1851, 1855, and 1859 have an on pixel in row 1822), a second row 1824 with only "off" pixels, and a third row 1826 with a "on" pixel every fourth column, but with the "on" columns in row 1826 centered between the "on" columns of row 1822 (i.e. columns 1851, 1852, 1854, 1855, 1856, 1858 and 1859 have off pixels and columns 1853 and 1857 have an on pixel in row 1826). A fourth row 1828 contains only "off" pixels. This four-row pattern also repeats four times. Thus, each of columns 1851-1859 have a plurality of instances in the pattern, wherein each of the 9 columns corresponds to one of the nine beams in an array. It should be understood that the pattern in FIG. 18 is only one example, without limitation, as any (preferably regular) pattern that uses all beams to create single pixel mask openings would work so long as each mask opening can be clearly identified without touching neighboring mask openings.

A first data array comprising a plurality of inspection parameters related to each of the plurality of openings in the mask layer of the digital inspection image is generated, and then a reference data array comprising a reconstruction of the first data array with idealized reference parameters for each of the plurality of openings in the mask layer is generated from data in the first data array. One or more deviations between corresponding reference parameters and inspection parameters are detected and calculated, and then a set of one or more correction factors for modifying the power intensity output of the one or more imaging beams based upon the detected and calculated one or more deviations is developed. The correction factors are then applied to the existing beam balancing information to form corrected beam balancing information.

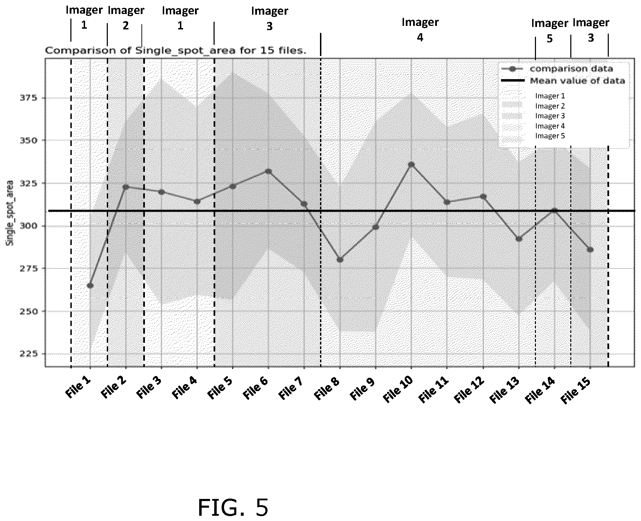

In another example, the disclosed systems and methods herein can be used for continuously or randomly monitoring the imaging quality, thereby permitting detection of a deterioration of the imaging quality before such deterioration materializes downstream, e.g. becomes visible in the print. In an exemplary embodiment, comparison of the plurality of inspection parameters from the first data array and a plurality of reference parameters from the second data array is displayed via an exemplary graphic user interface, such as shown in FIG. 5. Still further, the imaging quality assessment may be performed after imaging the full printing plate or after imaging a portion thereof (e.g. to form a small test pattern onto the printing plate). Additionally, the disclosed systems and methods herein can be implemented into UV curing stations, as described, for example, in US20220349796A1, titled PROCESS AND APPARATUS FOR AUTOMATIC MEASUREMENT OF DENSITY OF PHOTOPOLYMER PRINTING PLATES, which is incorporated herein by reference, or may be incorporated in combination with other imagers and UV curing stations. In particular, the image acquisition system as described herein may be structured similar to the density measurement system as described therein, wherein rather than a densitometer collecting radiation density information transmitted through a specialized target formed on the plate, a camera captures visual information at a suitable resolution to characterize the openings through which the non-actinic radiation is transmitted through or reflected by the plate.

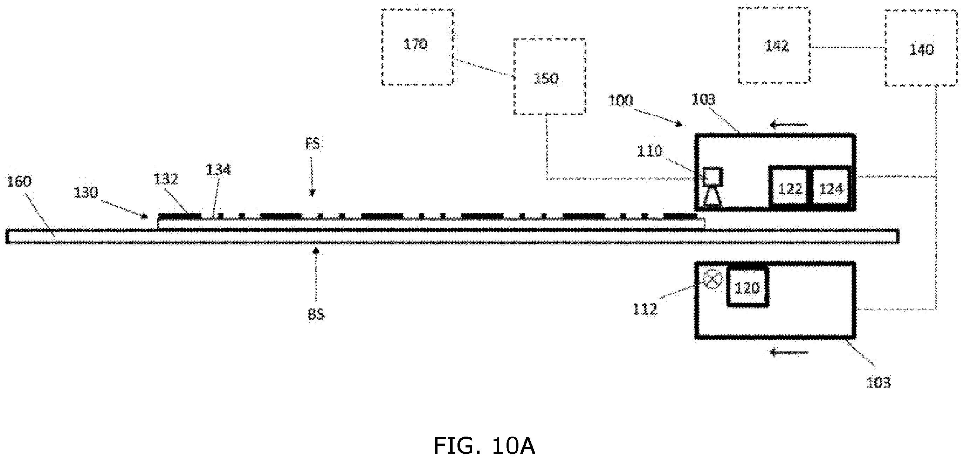

For example, the image acquisition system as described herein may be configured as schematically shown in FIG. 10A, which depicts an apparatus 100 for coordinated front and back exposure of a photosensitive printing plate 130 mounted on a transparent substrate 160 (such as glass) and comprising a photosensitive polymer 134 on which is disposed a laser-ablated mask (LAMS) layer 132. In the apparatus 100, a camera 110 -- configured to capture visual information at a suitable resolution to characterize the openings through which the non-actinic radiation (e.g. from source 112) is transmitted through the plate 130 -- is spaced apart from and adjacent a front side of the plate (FS), sometimes also referred to as the main side or printing side of the plate. One or more curing sources of actinic radiation 122, 124, for curing the plate from the front side, disposed adjacent to the camera 110. One or more curing sources of actinic radiation 120, for curing the plate from the back side, are provided. Although, multiple front side curing radiation sources 122, 124 are shown, other embodiments may have only a single curing source on the front side. Likewise, although only a single back side curing radiation source 120 is depicted, other embodiments may have multiple back side curing sources or no backside sources at all. Relative movement between the plate 130 and the image quality assessment system is triggered by a drive mechanism 140 controlled by a controller/control system 142, as is known in the art. Camera 110 may be attached to one or more processors 150, for operating the camera to acquire and store the image data in memory 170, and for processing the image data pursuant to the various processing techniques as discussed herein.

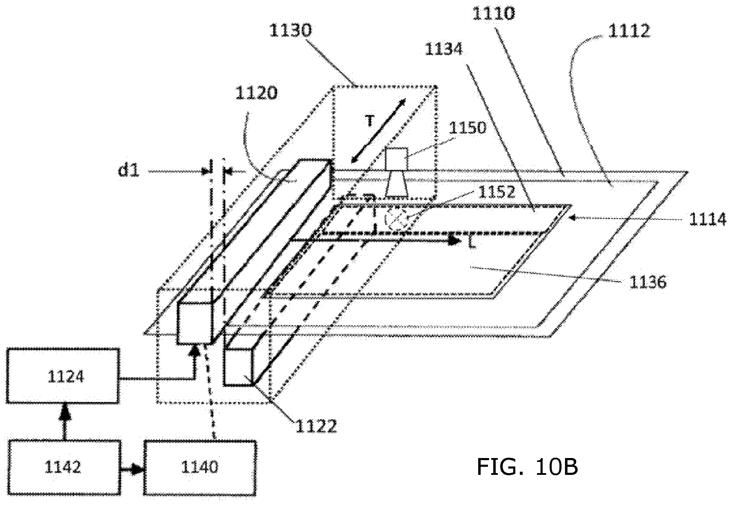

In another embodiment, as shown in FIG. 10B, the image quality assessment system described herein is integrated with linear exposure sources in a flatbed system. In the embodiment depicted in FIG. 10B, carriage 1130 represents a mechanism for moving both the front side actinic curing radiation source 1120 and back side linear radiation source 1122 relative to plate 1114 mounted on transparent surface 1112, such as a glass plate. Carriage 1130 may comprise a single housing split in the middle to accommodate the plate between an upper housing portion and a lower housing portions (e.g. upper housing 103 and lower housing 104 housings depicted in FIG. 10A, respectively). Each of the actinic radiation sources 1120, 1122 extend to cover one dimension of the plate, which in the example shown shall be referred to as the transverse direction. The carriage traverses the plate in the longitudinal (or lateral) direction along arrow L, with at least one source, and preferably both sources, activated. While the exposure step may be performed in a single pass, in some embodiments the exposure may be performed in a plurality of passes, in which each pass imparts radiation using both banks of sources at a fraction of the total exposure needed to provide a desired amount of exposure. Source 1120 is depicted as a single source in FIG. 10B to reduce clutter, but may comprise more than one source (such as in the embodiment depicted in FIG. 10A). Multiple sources may be used on the front side versus back side due to the relatively greater amount of exposure generally used on the front side relative to the back side, in practice.

The overall mechanism for creating the exposure may comprise a table having an outer frame 1110 that holds a transparent (e.g. glass) stage 1112 on which plate 1114 is disposed. In one embodiment, the upper portion of the carriage 1130 (disposed above the plate) holds the camera 1150 and the lower portion of the carriage holds non-actinic radiation source 1152 for providing light to be transmitted through the plate and the mask toward the camera. However, the relative positions above and below the plate of the source and the camera may be reversed. The positions of the camera 1150 and non-actinic radiation source 1152 may be stationary, or the camera 1150 and non-actinic radiation source may be fixed relative to one another, but configured to traverse the carriage 1130 in the transverse direction in the direction of arrow T using any mechanism for providing such motion as is known in the art. The radiation sources are coupled to a power source 1124, such as an electrical power cord having sufficient slack to extend the full range of motion of the carriage. Tracks (not shown) disposed on the outer frame portion provide a defined path for the gantry system or carriage to traverse. The carriage may be moved on the tracks by any drive mechanism 1140 known in the art (also coupled to the power supply 1124 and the controller 1142), including a chain drive, a spindle drive, gear drive, or the like. The drive mechanism for the carriage may comprise one or more components mounted within the carriage, one or more components fixed to the table, or a combination thereof. A position sensor (not shown) is preferably coupled to the carriage to provide feedback to the controller regarding the precise location of the carriage at any given time. The control signal output from the controller for operating the radiation sources and for controlling motion of the carriage may be supplied via a wired or wireless connection. The controller may be mounted in a fixed location, such as coupled to the table with a control signal cable attached to the sources similar to the power cable, or may be mounted in or on the carriage. The control system and drive mechanism cooperate to cause back and forth relative motion in a transverse direction between the radiation from the respective radiation sources and the plate. If should be understood that other embodiments may include a drive mechanism configured to move the portion of the table containing the plate past stationary upper and lower linear radiation sources, as well as embodiments in which the radiation sources cover less than the full width of the plate and are movable in both the transverse and longitudinal direction to provide total plate coverage (or the plate is movable in both directions, or the plate is movable in one of the two directions and the sources are movable in the other direction to provides the full range of motion required to cover the entire plate).

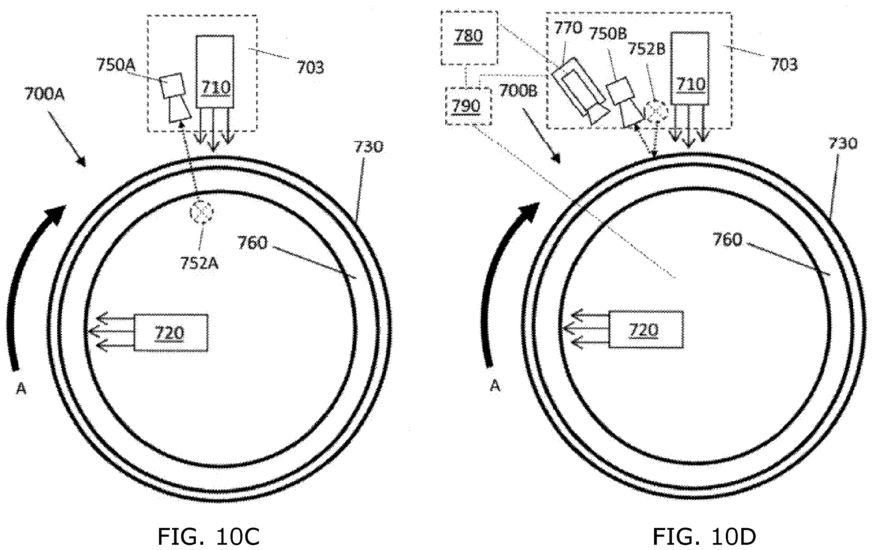

Furthermore, although shown in a flat orientation, it should be understood that the printing plate may be flexible enough to be disposed around a transparent cylinder, such as a glass cylinder, or the plate may be in the form of a continuous sleeve, as is known in the art, with the distances between the light sources arranged relative to the rotational direction of the cylinder, as generally depicted in FIG. 10C and described in more detail herein later.

In one embodiment 700A depicted in FIG. 10C, the printing plate 730 may be mounted on a transparent (e.g. glass) cylinder 760 rotating at a predetermined speed along arrow A, with the main actinic radiation source 710 disposed in a first location along the cylindrical path of rotation adjacent the external surface of the cylinder, and the back side actinic radiation source 720 disposed in a second location along the cylindrical path of rotation adjacent the internal surface of the cylinder, with the respective locations of the sources spaced apart by the distance required to provide a desired time delay between back and front exposure for the given speed of rotation. Sources 710 and 720 may be linear sources, or sources configured to travel parallel to the axis of rotation of the drum while the drum rotates.

Non-actinic radiation source 752A is disposed opposite camera 750A. The image capture system defined by non-actinic radiation 752A and camera 750A may be stationary, or may move in a transverse direction parallel to the axis of rotation of the drum. Although depicted with the non-actinic radiation 752A positioned with camera 750A housed in a common housing 703 with actinic curing radiation source 710, the invention is not limited to any particular disposition of the density measurement system. In other embodiments, the positions of the non-actinic radiation source 752A and the camera 750A may be reversed, or the components 750A, 752A may be disposed so that one or the other component may be commonly housed with actinic radiation source 720. In still other embodiments, the image capture system may be positioned along the circumference of the cylinder in any position desired. In such a system, the location of the actinic radiation sources and/or the speed of rotation may be variable to provide variable time delays, in which case the image capture system components are preferably in a fixed position, or positioned such that they retain a fixed relationship with one another, notwithstanding any repositioning of the actinic radiation sources. In embodiments in which the actinic radiation sources have a limited range of movement to provide variable time delay, the image capture components may be freestanding in a position that does not interfere with the range of movement of the actinic radiation components. The photosensitive printing plate 730 may be a sleeve, such as a sleeve designed to fit over the transparent cylinder 760 of the system described above, or may be flat, but sufficiently flexible, to permit it to be disposed on and secured to the surface of the cylinder. It should be understood that the term "transparent" as used herein may refer to any material that permits a desired amount of radiation at the desired wavelength pass through the selected material. Thus, "transparent" as used herein, may refer to a material that is not visibly transparent or even translucent to the human eye.

As depicted in each of FIGS. 10A, 10B, and 10C, the image capture system is a transmission-based system. Embodiments using image capture systems that provide the source and camera on the same side of the plate as the mask (i.e. the printing side) may also be used for practicing aspects of the invention. FIG. 10D depicts an embodiment 700B comprising a reflection arrangement, in which the non-actinic radiation source 752B is positioned not to emit light through the plate, but rather to reflect light off of the relevant portion of the plate (and mask) towards the camera 750B. The system 700A depicted in FIG. 2A (and 10C) is in every way otherwise identical to system 700B depicted in FIG. 10D. Although depicted in a drum arrangement, it should be understood that a reflection image capture configuration may also be used in a flatbed system as depicted in FIGS. 10A and 10B, in configurations that are identical to those depicted in FIGS. 10A and 10B, but with the non-actinic radiation source and camera disposed on the same side (i.e. front, mask side) of the plate in a reflective arrangement.

Additionally, or optionally, the disclosed systems and methods herein can be used for beam correction which improves or optimizes one or more beam balancing characteristics of imager 810, thereby mitigating or preventing instances of detected or measured imaging quality imperfections. With reference to the drum arrangement discussed above and illustrated in FIGS. 10C-10D, image capture or acquisition for use in the method of beam balancing correction, provides for light transmission through the mask layer by one or more illumination sources of non-actinic radiation from the front or printing side. Conventionally, this type of backlight illumination requires modifications to the drum arrangement or additional steps that are difficult to achieve. For example, openings into the side of the drum can be added, such that light can enter the drum through said openings and is reflected towards the backside of the plate via another set of openings defined by the cylinder surface of the drum. However, modifying the drum is typically cumbersome and expensive because of the high mechanical tolerances typically maintained for this approach, and changing the reflectance of the drum surface may undesirably change the imaging result.

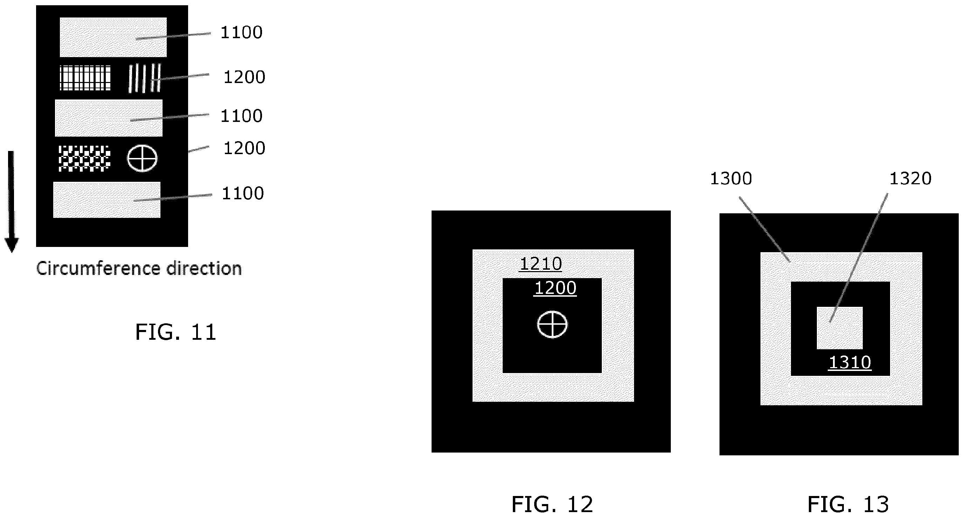

In contrast, turning now to FIGS. 11-13, the disclosed systems and methods herein provide for a backside illumination of the masking layer that enters the plate from the imaging/print or front side (i.e. from above the masking layer). In one non-limiting example, areas 1100 of the mask containing one or more test patterns are interrupted or surrounded by areas of plain areas of 100% mask openings (preferably created by ablation, but optionally created by any means) 1100, as illustrated in FIG. 11. Alternatively, the plurality of openings formed in the mask layer may be arranged such that the area containing the test patterns 1200 is surrounded by an area containing 100% mask openings 1210, as depicted in FIG. 12. Still further, FIG. 13 depicts an alternative configuration in which an empty (or blank, 100% opening) reference area 1320 in the center of a non-imaged area 1310 surrounded by 100% opening area) is used to create a background photo that can later be subtracted or removed from the photo of the test pattern (in order to avoid misinterpretation due to non-homogeneity by the ablation stain pattern (e.g. dust or tracks of on-removed LAMs between the beams or beam rakes) or the illumination itself).

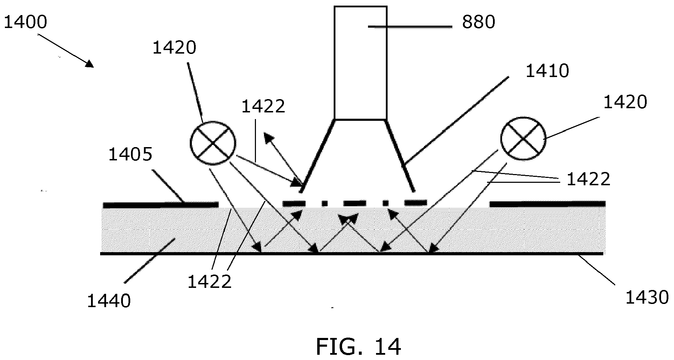

In an exemplary embodiment 1400, as depicted in FIG. 14, light is transmitted through the mask layer 1405 by one or more illumination sources 1420 of non-actinic radiation from the front side, such that light (as illustrated by rays 1422) illuminate the background of the test pattern after transmission through the polymer 1440 and reflection off of the backing layer 1430 of the printing plate precursor. Additionally, or optionally, shading 1410 is provided to prevent direct light from the illumination sources (as illustrated by rays 1424) reaching the camera from reflections from the top side of the mask.

In operation, a background image is captured of the reference area 1320 (FIG. 13) and an image of area 1200 (FIG. 12) containing the test pattern is also captured. The illumination readings from the reference area are subtracted from the illumination readings of the test pattern to obtain the true reading of the test pattern without inhomogeneity (e.g. due to the illumination through mask openings not being as homogenous as light from a light table from the back side of the plate). Thus, the disclosed systems and methods herein avoids the complicated, expensive alternative of changing the drum design for imaging quality assessment. In a preferred embodiment, the disclosed systems can be integrated or retrofitted on an imager to facilitate image quality assessment, without requiring changes to the conventional drum. Further, in embodiments in which the image capture systems and/or image quality assessment systems discussed herein are mounted on the imaging carriage, the analysis may be performed on any portion or location of the printing plate. In one non-limiting example, the test patterns may be imaged on waste portions of the plate. An advantage of imaging on a waste portion is that this imaging may be performed before imaging of the portion of the plate actually intended for printing, which may facilitate identification of problems with imaging quality (e.g. wrong focus position of imaging optics) before the critical part of the plate is image (thus avoiding the waste and delays of having to re-do an entire plate).

Finally, although referred to as a "camera," it should be understood that the image capture system is not limited to the use of visible wavelengths. The radiation used for image capture may be any wavelength, preferably one that does not cure the photopolymer (although embodiments may be implemented that utilize the actinic radiation during the curing process), and thus the image may be captured using any type of receiver configured to receive the transmitted or reflected non-actinic radiation in a manner capable of providing the information as described herein at the desired resolution.

The relative movement between the combined image capture / curing radiation sources and the plate may be provided by any mechanism known in the art for moving objects relative to a horizontal, vertical, or otherwise disposed stationary objects. For configurations in which the combined image capture / curing radiation sources move and the plate is stationary, for example, the sources may be disposed on a gantry system having arms that pass the respective sources on the relevant side(s) of a stationary plate. For configurations in which the combined image capture / curing radiation sources are stationary and the plate is movable, for example, the plate may be mounted on any mechanism known in the art, such as a movable stage configured to move relative to fixed image capture / curing radiation sources on opposite sides of the stage. The image capture system may also be applied to mechanisms for rotating a cylinder on which a plate is mounted relative to fixed image capture / curing radiation sources system. Similarly, mechanisms for rotating sources relative to a fixed cylinder on which the plate is mounted may also be used. Thus, mechanisms for moving one or more elements relative to another are well known in the art, generally, and the invention is not limited to any particular mechanism. By way of example, an image capture system as described herein may be integrated with any of the mechanisms for providing relative movement between a plate and front/back curing exposure sources as discussed in U.S. Patent Application Publication No. 2018/0210345, titled PROCESS AND APPARATUS FOR CONTROLLED EXPOSURE OF FELXOGRAPHIC PRINTING PLATES AND ADJUSTING THE FLOOR THEREOF, assigned to the common assignee of the present invention, and incorporated herein by reference in its entirety.

Further, the disclosed systems and methods herein can be implemented into a fully automated production system for printing plates, as described for example, in US20230126302A1, WO2022144291A1 or US20200016916A1 (titled SYSTEM AND PROCESS FOR PERSISTENT MARKING OF FLEXO PLATES AND PLATES MARKED THEREWITH), all of which are incorporated herein by reference. Finally, the disclosed systems and methods herein are not limited to performing an imaging quality assessment of the mask layer or film required for UV curing of flexographic printing plates; rather, the disclosed systems and methods herein can also be applied to the cured and processed printing plates, in which a picture of the microstructures on the plate can be analysed similarly (e.g. assess size of the final microdots). In this way, the disclosed systems and methods for imaging quality assessment is useful to verify that one or more steps involved in the overall preparation of a printing plate (e.g. UV curing, processing (washing the plate), drying and/or UV finishing) has been executed properly or meet the desired expectations.

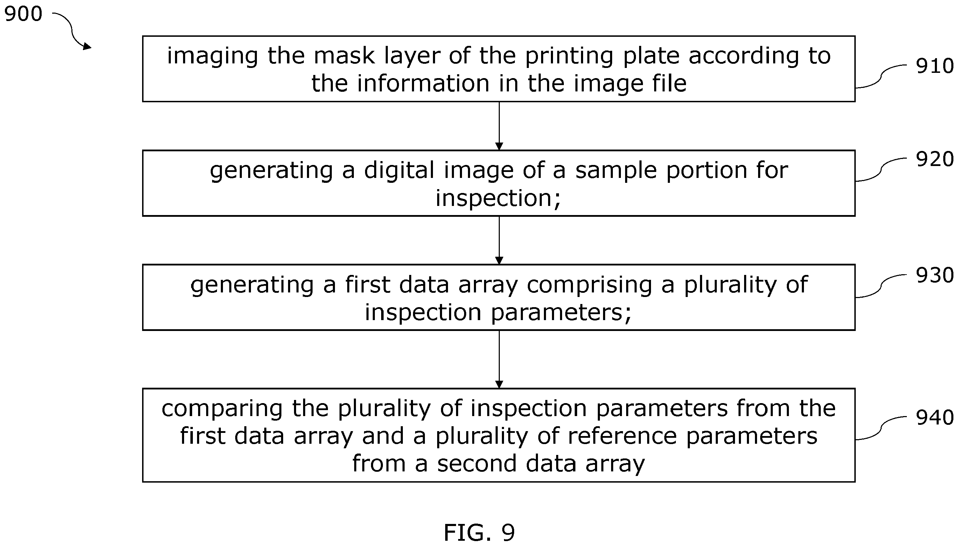

Referring now to FIG. 9, a method 900 for performing an image quality analysis of a printing plate is disclosed. The printing plate includes a printing surface corresponding to an information in an image file, and the information in the image file includes micro-screen information comprising a pattern of "on" and "off" single pixels or a cluster thereof. Additionally, the printing plate comprises a photopolymer cured through openings in a mask layer. Additional details of the method 900 is discussed below in the context of the system 800 described above.

In step 910, a mask layer of the printing plate is imaged according to the information in the image file. In an exemplary embodiment, the controller 820 connected to the imager 810 is configured to transform image information in the image file to commands for causing the imager 810 to create the openings in the mask layer.

In step 920, a digital image of a sample portion of at least the openings formed in the mask layer corresponding to the micro-screen information is generated for inspection. In an exemplary embodiment, as shown in FIGS. 7A-7C, the digital image comprises a set of horizontal and vertical stripes corresponding to at least one group of openings in the mask layer forming horizontal rows or vertical columns of openings, respectively.

In step 930, a first data array comprising a plurality of inspection parameters related to the individual openings in the mask layer is generated. In an exemplary embodiment, the plurality of reference parameters and plurality of inspection parameters comprise a size, a shape, a position, an orientation (relative to each other), and a homogeneity of the pattern of openings. Additionally, or optionally, optimal parameters related to the openings in the mask layer are generated based on the digital image of the sample portion. In one example, an average value is calculated for each respective one of the plurality of inspection parameters, such that, a second data array comprising optimal parameters is generated by assessing the plurality of inspection parameters and the calculated average values thereof.

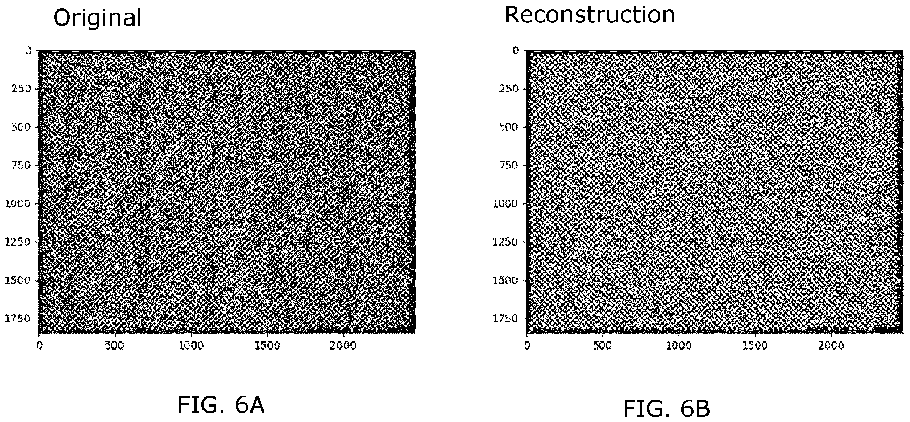

In step 940, a plurality of inspection parameters from the first data array is compared with a plurality of reference parameters from a second data array. Additionally, or optionally, the plurality of inspection parameters from the first data array is compared with a plurality of ideal parameters determined from a reconstruction of the plurality of inspection parameters (as shown and discussed with references to FIGS. 6A-6B herein). Correction values are calculated based upon deviations between the inspection parameters as shown in FIG. 6A and the ideal reconstruction as shown in FIG. 6B and those correction values are applied to improve the balancing of the beams. In an exemplary embodiment, when the digital image comprises a set of horizontal and vertical stripes corresponding to at least one group of openings in the mask layer forming horizontal rows or vertical columns of openings, respectively, differences in average mask opening can be assessed or determined along horizontal and vertical directions. In this aspect, the horizontal and vertical stripes correspond to relatively lighter (see 302 in FIG. 3) or darker stripes (see 301 in FIG. 3) in a mask layer comprising microcells patterns. Various imaging imperfections may contribute to the resulting horizontal and vertical stripes of varying light transmissivity, such as misbalancing, wrong beam positioning and modulating patterns. However, these darker or lighter stripes of light transmission in the mask layer, while perceptible to the human eye, are complex and difficult to quantify for comparison. In most cases, these imperfections result in visible stripes that are oriented along the imaging direction, direction, and can sometimes be transferred into the print.

Additionally, or optionally, in step 950, when one or more deviations between the plurality of inspection parameters and the plurality of reference or ideal parameters, or other imaging imperfections, are measured or detected (e.g. due to a misbalancing of the beams), one or more compensation factors for the measured or detected imaging imperfection is applied (e.g. for balancing the imaging beams), as described herein, thereby mitigating or eliminating the detected or measured imperfections.

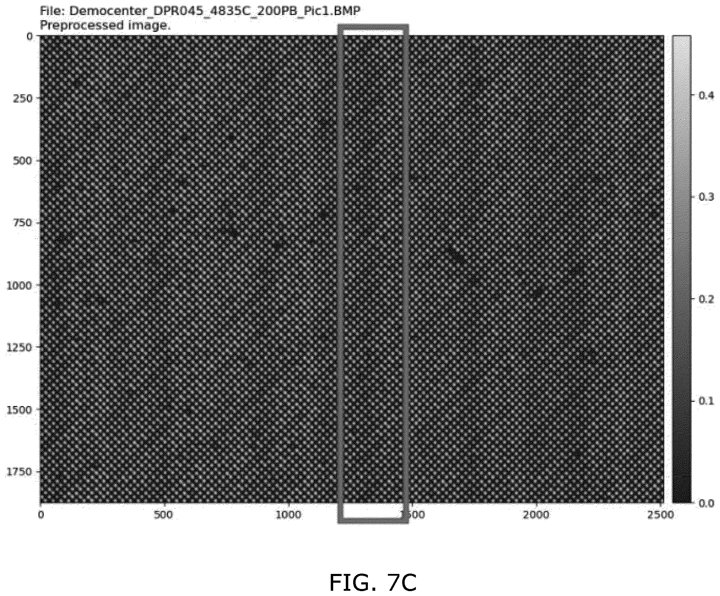

FIG. 7C illustrates a digital image generated in step 910, the digital image comprising such horizontal and vertical lines/stripes (in this case, imaging direction is along the vertical direction). In this case, the image is sliced into a multitude of horizontal and vertical slices that are oriented parallel to the lines that are constituted by the horizontal and vertical rows of mask openings. The average light transmission of each slice is then analysed and displayed in a graph as depicted in FIGS. 7A and 7B. In FIG. 7A, light transmission average readings of the vertical rows of mask openings and mask non-openings from the digital image in FIG. 7C are shown. In FIG. 7B, light transmission average readings of the horizontal rows are shown. The scale on the right of the graphs in FIGS. 7A and 7B represents the average light transmission through the mask layer (e.g. by one or more illumination sources of non-actinic radiation). The scale at the bottom stands for the number of the row that is analysed. As is illustrated, the light transmission of the analysed vertical rows fluctuates relatively more compared to that of the horizontal rows, thereby confirming the visual impression that the picture in FIG. 7C has visible vertical lines. In other words, an improved or more precise and impartial/objective assessment of the strength of the visible stripes and their probability for ink transfer is provided by the disclosed systems and methods herein.

In another exemplary embodiment, the digital image is used to build or reconstruct another image having ideal mask openings. This reconstruction of the original image makes it easier to identify incorrect or inaccurate placement of mask openings, and can be used to analyze the difference between the plurality of inspection parameters and the plurality of reference parameters corresponding to optimal parameters (e.g. regarding position of mask openings). Such a reconstruction based on the digital image is shown in FIG. 6B, which may be stored in computer memory media 840 and/or without being displayed to human operators via an exemplary user interface. Thus, in operation, the plurality of reference parameters from the third data array comprising at least calculated average values of the plurality of inspection parameters is shown in FIG. 6A, and the reconstruction image having ideal mask openings, as shown in FIG. 6B, facilitates a comparison between the first data array or the second data array to the third data array, thereby allowing for detection of one or more deviations between the plurality of inspection parameters from the first data array or the second data array and the plurality of reference parameters from the third data array. In this way, based on these deviations, correction values are calculated (and may be stored in yet another data array) and applied to improve the balancing between individual beams of the imager 810.

Although the invention is illustrated and described herein with reference to specific embodiments, the invention is not intended to be limited to the details shown. Rather, various modifications may be made in the details within the scope and range of equivalents of the claims and without departing from the invention.

While preferred embodiments of the invention have been shown and described herein, it will be understood that such embodiments are provided by way of example only. Numerous variations, changes and substitutions will occur to those skilled in the art without departing from the spirit of the invention. Accordingly, it is intended that the appended claims cover all such variations as fall within the spirit and scope of the invention.

## Claims

1. A system for performing quality analysis of an imaged printing plate precursor mask layer having a plurality of openings created by a first imager corresponding to information in an image file, the information in the image file including micro-screen information comprising a pattern of "on" and "off" single pixels or clusters thereof, the printing plate precursor comprising a photopolymer configured to be cured by exposure to actinic radiation through openings in a mask layer, the system comprising:
a detector for acquiring a digital image of at least a sample portion of the plurality of openings formed in the mask layer corresponding to the micro-screen information for inspection;
computer memory media programmed with a first set of machine-readable instructions for causing a processor to analyze the digital image and generate, based on the digital image, a first data array comprising a plurality of inspection parameters related to each of the plurality of openings in the mask layer; and
computer memory media programmed with a second set of machine-readable instructions for comparing the plurality of inspection parameters from the first data array and a plurality of reference parameters from a second data array.

2. The system of claim 1, wherein the plurality of reference parameters and plurality of inspection parameters comprise size, shape, position, and homogeneity of the plurality of openings formed in the mask layer.

3. The system of claim 1, wherein the detector comprises a camera and optionally, an optical element to generate a magnified digital image of the sample portion.

4. The system of claim 3, wherein the camera comprises a plurality of pixels that is at least 500 times more than a number of the plurality of openings in the sample portion for inspection.

5. The system of claim 2, wherein the third set of machine-readable instructions comprises instructions for calculating an average value for each respective one of the plurality of inspection parameters.

6. The system of claim 5, wherein the third set of machine-readable instructions further comprises instructions for generating the second data array comprising at least the calculated average values of the plurality of inspection parameters.

7. The system of claim 6, wherein the third set of machine-readable instructions comprises instructions for detecting one or more deviations between the plurality of inspection parameters from the first data array and the plurality of reference parameters from the second data array.

8. The system of claim 7, wherein the second set of machine-readable instructions comprises instructions for causing the processor to render and an output device attached to the processor to output an image visualizing the comparison of and deviations between the plurality of inspection parameters from the first data array and the plurality of reference parameters from the second data array.

9. The system of claim 7, further comprising computer memory media programmed with a third set of machine readable instructions comprising instructions for comparing the one or more deviations detected using a first instance of the first data array generated at a first time to the one or more deviations detected using a second instance of the first data array generated at a second time, and providing an alert if the comparison indicates a change over time greater than a predetermined threshold.

10. The system of claim 7, further comprising computer memory media programmed with a third set of machine-readable instructions for retrieving a third data array comprising at least calculated average values of the plurality of inspection parameters for one or more imagers other than the first imager, comparing the first data array or the second data array to the third data array, and detecting one or deviations between the plurality of inspection parameters from the first data array or the second data array and the plurality of reference parameters from the third data array.

11. The system of claim 9 or claim 10, further comprising:
at least the first imager;
a controller connected to the first imager; and
computer memory media programmed with a fourth set of machine-readable instructions for causing the controller connected to the first imager to transform image information in the image file to commands for causing the first imager to create the plurality of openings in the mask layer.

12. The system of claim 11, further comprising computer memory media programmed with a fifth set of machine-readable instructions for recommending or automatically initiating a change in at least one setting of the controller connected to the first imager based upon the detected one or more deviations.

13. The system of claim 12, wherein the at least one setting is selected from the group consisting of a balance setting, a beam positioning setting, and a modulation pattern setting.

14. The system of claim 3, further comprising an illumination source configured to provide non-actinic radiation to illuminate the mask for acquiring the digital image with the camera.

15. The system of claim 14, wherein the illumination source is located on an opposite side of the mask from the camera.

16. The system of claim 14, wherein the illumination source is located on a same side of the mask as the camera, and the plate precursor has structures formed in the mask layer configured to permit acquisition of the digital image using light from the illumination source transmitted through the structures to reflect from a backing layer of the print precursor to backlight a test pattern in the mask layer.

17. The system of claim 16, wherein the structures include a first structure having a test pattern and a second structure configured to serve as a reference structure configured such that illumination readings from a reference area of the reference structure subtracted from the illumination readings of the test pattern eliminate artifacts in the captured image of the test pattern due to inhomogeneity from unintended illumination.

18. The system of claim 14, wherein the camera is mounted on an exposure system having one or more sources of the actinic wavelength and configured to cause relative motion between the one or more sources and the printing plate precursor during an exposure step, wherein the illumination source and the camera are positioned on the exposure system and the exposure system is configured to cause the relative motion during illumination of the illumination source to facilitate acquisition of the digital image by the camera.

19. A method for performing quality analysis of an imaged printing plate precursor mask layer having a plurality of openings created by a first imager corresponding to information in an image file, the information in the image file including micro-screen information comprising a pattern of "on" and "off" single pixels or clusters thereof, the printing plate precursor comprising a photopolymer configured to be cured by exposure to actinic radiation through openings in a mask layer, the method comprising:
imaging the mask layer of the printing plate according to the information in the image file by causing the controller connected to the imager to transform image information in the image file to commands for causing the imager to create the openings in the mask layer;
generating a digital image of at least a sample portion of the plurality of openings formed in the mask layer corresponding to the micro-screen information for inspection;
generating a first data array comprising a plurality of inspection parameters related to each of the plurality of openings in the mask layer; and
comparing the plurality of inspection parameters from the first data array and a plurality of reference parameters from a second data array.

20. The method of claim 19, wherein the plurality of reference parameters and plurality of inspection parameters comprise size, shape, position, and homogeneity of the plurality of openings formed in the mask layer.

21. The method of claim 20, further comprising generating optimal parameters related to the openings in the mask layer based on the digital image of the sample portion and populating the second data array with the optimal parameters.

22. The method of claim 21, wherein the digital image comprises a set of horizontal and vertical stripes corresponding to at least one group of openings in the mask layer forming horizontal rows or vertical columns of openings, respectively.

23. The method of claim 22, wherein at least one horizontal stripe differs from at least one other horizontal stripe, or at least one vertical stripe differs from at least one other vertical stripe, in a manner corresponding to a relative difference in light transmissivity of the mask, and the method further comprises determining if the relative difference exceeds a threshold corresponding to expected detectability in a printed image to be made from a finished plate created from the plate precursor, and changing one or more settings of the imager if the relative difference exceeds the threshold.

24. The method of claim 20, further comprising exposing the printing plate to one or more non-actinic radiation sources having a non-actinic wavelength suitable for transmitting light through the photopolymer and the openings in the mask but not for curing the photopolymer of the printing plate, wherein detecting and calculating one or more deviations between respective reference parameters and inspection parameters comprises analyzing an average transmittivity of emitted radiation through the mask layer.

25. The method of claim 24, wherein the imager comprises a plurality of imaging beams, further comprising adjusting power of one or more of the imaging beams to provide balanced ablation of the plurality of openings in the mask layer for optimization of ink transfer in press based upon the detected and calculated one or more deviations.

26. The method of claim 25, wherein adjusting power comprises developing a set of one or more correction factors for modulating a power intensity output of the one or more imaging beams.

27. Non-transitory computer memory media programmed with machine-readable instructions for causing a processor to perform quality analysis of a printing plate mask layer created by an imager based upon information in an image file including micro-screen information comprising a pattern of "on" and "off" single pixels or clusters thereof, the instructions including:
a first set of instructions for retrieving a digital image of at least a sample portion of the openings formed in the mask layer corresponding to the micro-screen information for inspection;
a second set of machine-readable instructions for analyzing the digital image and generating, based on the digital image, a first data array comprising a plurality of inspection parameters related to the individual openings in the mask layer;
a third set of machine-readable instructions for comparing the plurality of inspection parameters from the first data array and a plurality of reference parameters from a second data array;
a fourth set of machine-readable instructions comprising at least one of:
instructions for comparing the one or more deviations detected using a first instance of the first data array generated at a first time to the one or more deviations detected using a second instance of the first data array generated at a second time, and providing an alert if the comparison indicates a change over time greater than a predetermined threshold, and
instructions for retrieving a third data array comprising at least the calculated average values of the plurality of inspection parameters for one or more imagers other than the first imager, comparing the first data array or the second data array to the third data array, and detecting one or more deviations between the plurality of inspection parameters from the first data array or the second data array and the plurality of reference parameters from the third data array; and
a fifth set of machine-readable instructions comprising at least one of:
instructions for recommending or automatically initiating a change in at least one setting of the imager based upon the detected one or more deviations; and
instructions for causing the processor to render, and an output device attached to the processor to output, an image visualizing the comparison of and deviations between the plurality of inspection parameters from at least two of the first instance of the first data array, the second instance of the second data array, the second data array, and the third data array.

28. The non-transitory computer memory media of claim 27, wherein the instructions for recommending or automatically initiating a change in at least one setting of the imager include one or more correction factors for modulating a power intensity output of one or more imaging beams of an imager to provide balanced ablation of the plurality of openings in the mask layer for optimization of ink transfer in press based upon the detected one or more deviations.

29. The non-transitory computer memory media of claim 27, wherein the printing plate mask layer comprises a first structure having a test pattern and a second structure configured to serve as a reference structure, wherein the second set of machine-readable instructions for analyzing the digital image includes subtracting captured information of the reference structure from captured information of the test pattern.

30. The non-transitory computer memory media of claim 27, further comprising a set of instructions for controlling an image capture system for retrieving the digital image of the mask openings, the image capture system comprising an illumination source and a camera mounted on an exposure unit and configured to travel to at least a designated location of the mask layer, wherein the instructions include instructions for controlling the illumination source and the camera to capture at least one image at the designated location, wherein the image captures at least a portion of the test pattern representative of mask openings from all imaging beams intended for use in a subsequent imaging process to be performed after the balancing.

31. A method for imaging beam balancing of an imager, the imager configured to emit a plurality of imaging beams for ablating a plurality of openings in a mask layer of a printing plate precursor in accordance with pattern information in an image file, the pattern information corresponding to a plurality of single pixel mask openings wherein each single pixel mask opening does not touch neighboring mask openings, the imager comprising a controller configured to translate the information in the image file into an amount of energy selectively applied by the plurality of imaging beams to selected locations on the mask layer, the imager having initial beam balancing information stored in computer memory and used by the controller for defining a power intensity output supplied to each imaging beam, the method comprising:
imaging the mask layer of the printing plate with the imager according to the information in the image file using the initial beam balancing information;
generating a digital inspection image of at least a sample portion of the plurality of openings formed in the mask layer imaged using the initial beam balancing information;
generating a first data array comprising a plurality of inspection parameters related to each of the plurality of openings in the mask layer of the digital inspection image;
generating a reference data array comprising a reconstruction of the first data array with idealized reference parameters for each of the plurality of openings in the mask layer generated from data in the first data array;
detecting and calculating one or more deviations between corresponding reference parameters and inspection parameters;
developing a set of one or more correction factors for modifying the power intensity output of the one or more imaging beams based upon the detected and calculated one or more deviations, and applying the one or more correction factors to the existing beam balancing information to form a corrected beam balancing information.

32. The method of claim 31, further comprising replacing the existing beam balancing information stored in the computer memory with the corrected beam balancing information.

33. The method of claim 31 or claim 32, wherein the idealized reference parameters are based on average values for the plurality of inspection parameters in the first data array.

34. The method of any one of claims 31 - 33, wherein the information in the image file for creating the plurality of openings in the mask layer comprises a pattern configured to utilize at least all imaging beams of the imager intended for use in an imaging process to be performed after the balancing.
